# EUROPEAN PATENT APPLICATION

(11) **EP 4 459 836 A1**
(43) Date of publication of application: **06.11.2024**
(21) Application number: 24174035.6
(22) Date of filing: 03.05.2024
(51) Int. Cl.: H02J 50/00

(54) **WIRELESS CHARGING DEVICE**

(30) Priority: 03.05.2023 US 202363463623 P; 30.04.2024 US 202418650763
(71) Applicant: Aptiv Technologies AG, 8200 Schaffhausen (CH)
(72) Inventor: ANDRE, Michael James, 8200 Schaffhausen (CH); GUZDEK, John F., 8200 Schaffhausen (CH)
(74) Representative: Bardehle Pagenberg Partnerschaft mbB Patentanwälte Rechtsanwälte

(57) **Abstract**

A wireless charging device (100, 600) may include a source coil (208, 712) configured to transmit electric power to a receiver coil in a separate device (402). The wireless charging device (100, 600) may include a housing (204, 704) having a pedestal (102, 706) projecting from the housing (204, 704) in which the source coil (208, 712) is disposed. The housing (204, 704) defines a plurality of first air vents (106, 708) located circumferentially around the pedestal (102, 706). The wireless charging device (100, 600) may include an air movement device (214, 718) disposed within the housing (204, 704). The wireless charging device (100, 600) may include an electronic controller (302) disposed on a printed circuit board (202, 702) and configured to control airflow through the air movement device (214, 718).

## Description

This disclosure is directed to a wireless charging device, particularly to a wireless charging device with a fan configured to cool the wireless charging device and or the device being charged.

Typical active cooling schemes for automotive wireless chargers use a radial fan mounted on the wireless charging module to blow or suck air through an airduct built into the interface surface of the module between the wireless power transmitter and the wireless power receiver. During charging, this airflow typically either blows directly onto the receiver through holes in the interface surface to cool the receiver or blows under the interface surface to insulate the receiver from heat generated by the transmitter.

Airflow configurations that intake air from spaces below the charger can be subject to higher cooling air temperatures as this space is typically below the vehicle console/trim and is not climate controlled may contain hotter air when the charger is being used in high outside temperature conditions, thereby reducing cooling efficiency in the scenario where the cooling is needed most. Airflow configurations that intake air from the climate-controlled cabin and pass it around the phone to exhaust below the module do not have this problem, but these configurations usually cause the transmitter module to have larger packaging size, especially in the Z-axis/height direction, in order to fit the necessary mounts and ducting to maintain low enough system pressure for the fan to generate sufficient cooling airflow.

These problems are most likely understood by most competitors and customers who use active cooling in their transmitter designs. These issues can be minimized with clever or more expensive design, but to a degree they are innate to the application.

In some aspects, the techniques described herein relate to a wireless charging device, including: a source coil configured to transmit electric power to a receiver coil in a separate device; a housing having a pedestal projecting from the housing in which the source coil is disposed. The housing defines a plurality of first air vents located circumferentially around the pedestal. An air movement device disposed within the housing.

Embodiments of the present invention will now be described by way of example with reference to the accompanying drawings, in which:
FIG. 1 is an isometric view of a wireless charging device having a central fan according to some embodiments.
FIG. 2 is an isometric cross-section view of the wireless charging device of FIG. 1 according to a some embodiments.
FIG. 3 is a schematic diagram of the wireless charging device of FIG. 1 according to a some embodiments.
FIG. 4 illustrates an isometric view of the wireless charging device of FIG. 1 and a consumer device being charged by the wireless charging device according to some embodiments.
**FIG. 5** illustrates a side cross-sectional view of the wireless charging device of **FIG. 1** according to a some embodiments.
**FIG. 6** illustrates an isometric view of a wireless charging device having an offset fan and a spiral air duct according to some embodiments.
**FIG. 7** illustrates an exploded view of the wireless charging device of **FIG. 6** according to some embodiments.
**FIG. 8** illustrates a top view of a cover of the wireless charging device of **FIG. 6** according to some embodiments.
**FIG. 9** illustrates an isometric bottom view of the wireless charging device of **FIG. 6** according to some embodiments.
**FIG. 10** illustrates an isometric bottom view of the wireless charging device of **FIG. 6** with a bottom cover removed according to some embodiments.
**FIG. 11** illustrates a side cross-sectional view of the wireless charging device of **FIG. 6** according to some embodiments.
**FIG. 12** illustrates an isometric bottom view of the top cover of the wireless charging device of **FIG. 6** according to some embodiments.
**FIG. 13** illustrates a side cross-section view of the top cover of the wireless charging device of **FIG. 6** according to some embodiments.
**FIG. 14** illustrates a side cross-sectional view of the wireless charging device of **FIG. 6** and a consumer device being charged by the wireless charging device according to some embodiments.

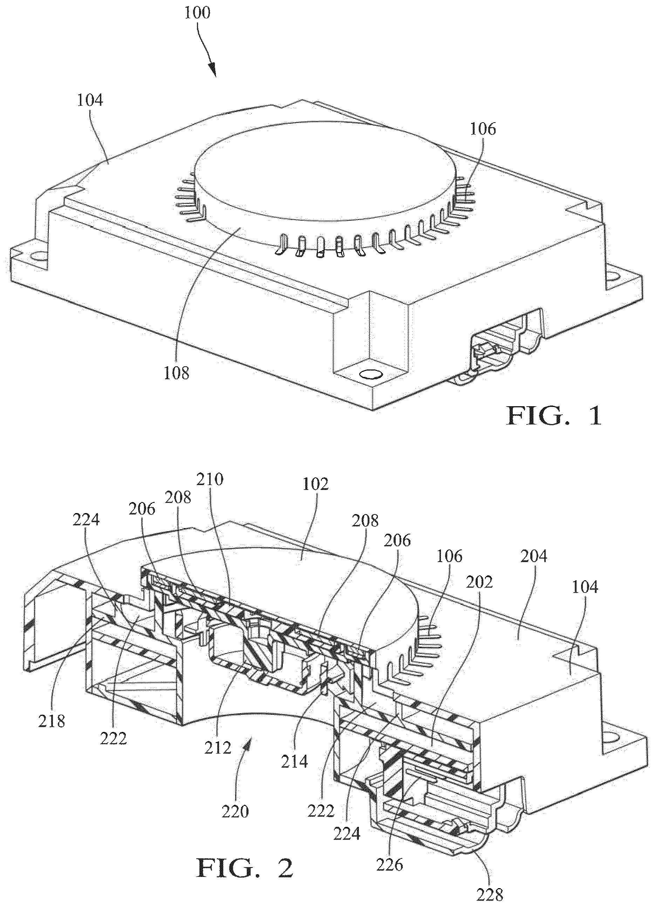

A first non-limiting example of a wireless charging device, hereafter referred to as the device 100 is shown in **FIG. 1****.** The device 100 is configured to change a wireless charging enabled device, such as a cellular telephone, resting on a generally cylindrical pedestal 102 extending from a top surface 104 of the device 100. The pedestal contains a source coil (see **FIG. 2**) which produces an electromagnetic field which is inductively coupled with a receiving coil in the wireless charging enabled device. The pedestal 102 also contains an array of alignment magnets (see **FIG. 2**) that interact with a corresponding array of locating magnets in the wireless charging enabled device to provide optimal alignment between the source coil and the receiving coil. The pedestal 102 also defines a plurality of air vents 106 that are arranged circumferentially around the pedestal 102. In the illustrated example the plurality of air vents 106 are arranged around the base 108 of the pedestal 102.

As shown in **FIG. 2****,** the device 100 includes a printed circuit board assembly, hereafter referred to as the PCBA 202 having a plurality of electronic devices such as an antenna, e.g., a near field communication (NFC) antenna, configured to communicate with the wireless charging enabled device, microcontrollers, capacitors, resistors, diodes, transistors, etc., disposed thereon. The device 100 further includes an outer housing 204 defining the pedestal 102 and containing the magnet array 206. The magnet array 206 includes aligning magnets, such as those used with MAGSAFE^{™} devices produced by or under license from Apple Inc. and/or used with Magnetic Power Profile devices conforming to the Qi2 standards maintained by the Wireless Power Consortium. The device 100 further includes a source coil 208, a ferrite 210, a fan base 212, and a fan 214. The fan 214 is positioned and located in the outer housing 204 coaxially with the source coil 208 and the ferrite 210 such that it will cool the PCBA 202, the source coil 208, and the ferrite 210 as well as a wireless charging enabled device on the pedestal 102 by air flow through the plurality of air vents 106.

The device 100 also includes an inner housing 218 that defines a central air vent 220 which is coaxially located with the fan 214. Depending on the configuration of blades of the fan 214 and/or a rotational direction of the fan 214, air can flow through the device 100 by entering into the plurality of air vents 106 and exiting through the central air vent 220 or air can enter the central air vent 220 and exit through the plurality of air vents 106.

As further illustrated in **FIG. 2****,** the inner housing 218 defines a channel 222 that is formed by a wall 224 which surrounds the central air vent 220. The wall 224 is positioned outboard of the plurality of air vents 106. The channel 222 is configured to direct any liquids, e.g., water, soda, which may enter the device 100 through the plurality of air vents 106 out of the device 100 through the central air vent 220 under the force of gravity. The channel 222 is configured to protect at least the PCBA 202 and the fan 214 from any contact with the liquid.

**FIG 2** also shows the device 100 has an electrical connector 226 which is connected to the PCBA 202. The electrical connector 226 is configured to connect the device 100 to external electrical devices, such as power supplies or external sensors. The device 100 also includes a bottom cover 228 enclosing the inner housing 218 within the outer housing 204.

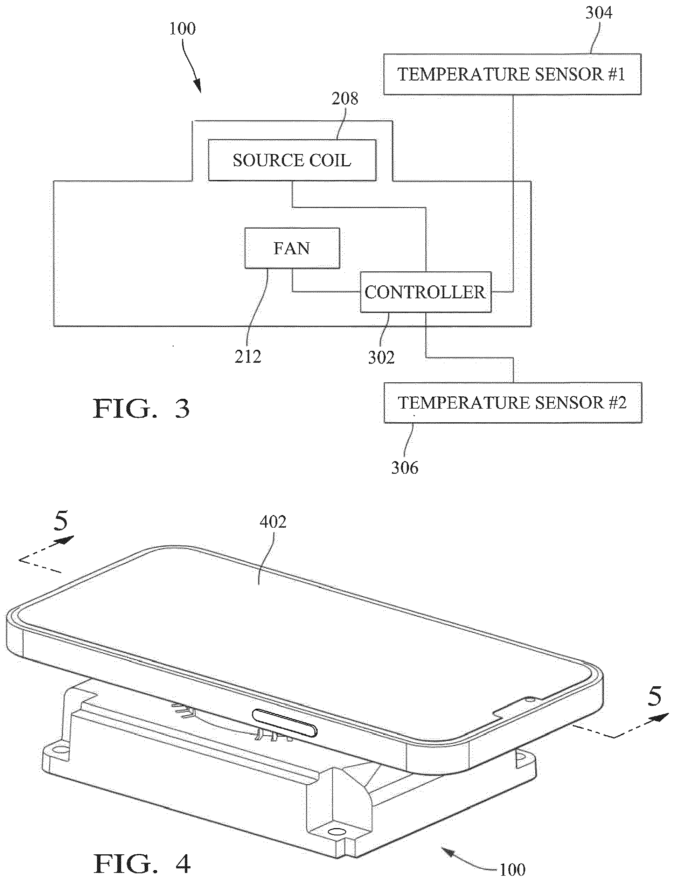

As illustrated in the schematic diagram **FIG. 3****,** the device 100 also includes an electronic controller 302 that is located on the PCBA 202. The electronic controller 302 is in electronic communication with at least the source coil 208 and the fan 214 to control the charging of the wireless charging enabled device by the source coil 208 and the cooling of the device 100 by the fan 214.

As shown in **FIG 3****,** an electronic controller 302, e.g., a microprocessor on the PCBA 202, may also be in electronic communication with one or more temperature sensors. The illustrated example of **FIG. 3** includes two temperature sensors. The first temperature sensor 304 may be placed on a side of the device 100 nearer the plurality of air vents 106 and the second temperature sensor 306 is placed nearer the central air vent 220. The first and second temperature sensors may be located external to the device 100 or they may the disposed within the device 100. The electronic controller 302 may be configured to control the direction of rotation of the fan 214 to draw air into the plurality of air vents 106 and exhaust air from the central air vent 220 when the first temperature sensor 304 indicates a lesser temperature than the second temperature sensor 306 or the electronic controller 302 may be configured to control the direction of rotation of the fan 214 to draw air into the central air vent 220 the plurality of air vents 106 and exhaust air from the plurality of air vents 106 when the first temperature sensor 304 indicates a greater temperature than the second temperature sensor 306. The first and second temperature sensors 304, 306 may be connected to the device 100 via the electrical connector 226.

In an alternative embodiment of the device 100, a single temperature sensor that is located in or near the central air vent 220 may be employed rather than the first and second temperature sensors 304, 306. The electronic controller 302 may be configured to control the direction of rotation of the fan 214 to draw air into the device 100 through the central air vent 220 for a first time period, e.g., 10 seconds and then reverse direction of rotation of the fan 214 to draw air into the device 100 through the plurality of air vents 106 for a second time period, e.g., 10 seconds. The electronic controller 302 monitors the temperature indicated by the single temperature sensor during the first and second time periods and then commands the fan 214 to draw air into the housing through the central air vent 220 if the temperature indicated by the single temperature sensor is lower during the first time period than the second time period to provide the most efficient cooling for the device. The electronic controller 302 commands the fan 214 to draw air into the housing through the plurality of air vents 106 if the temperature indicated by the single temperature sensor is lower during the second time period than the first time period to provide the most efficient cooling for the device.

**FIG. 4** illustrates an isometric view of the 100 and a wireless charging enabled device 402 resting on the pedestal 102. The device 100 is configured to charge the wireless charging enabled device 402 while actively cooling the device 100 and/or the wireless charging enabled device 402 in order to have a higher and/or more consistent charge rate in addition to the liquid contaminant protection described above.

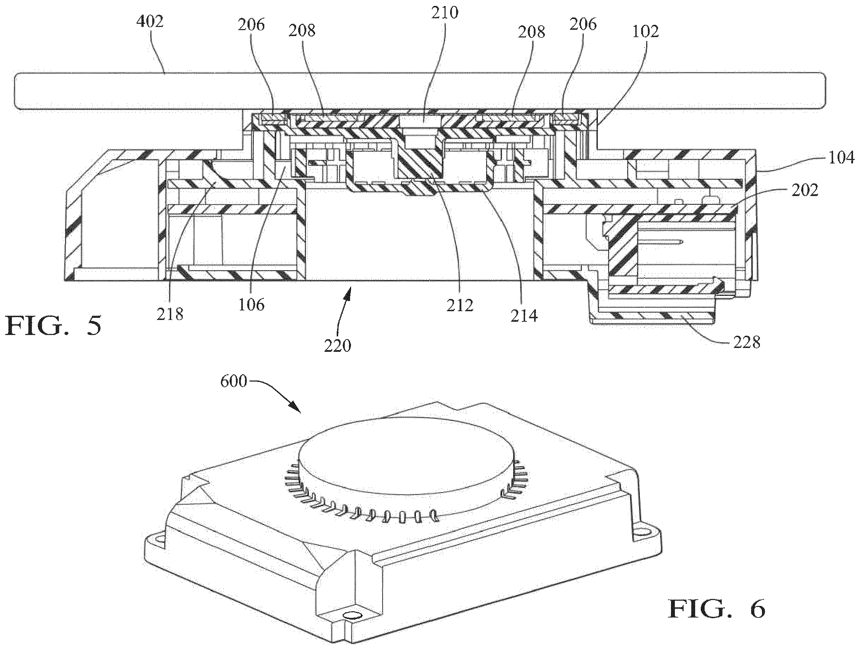

**FIG. 5** shows a cross-section view of the device 100 with the wireless charging enabled device 402 resting on the pedestal 102 and properly aligned with the source coil 208 by the magnet array 206.

A second non-limiting example of a wireless charging device, hereafter referred to as the device 600 is shown in **FIG. 6****.**

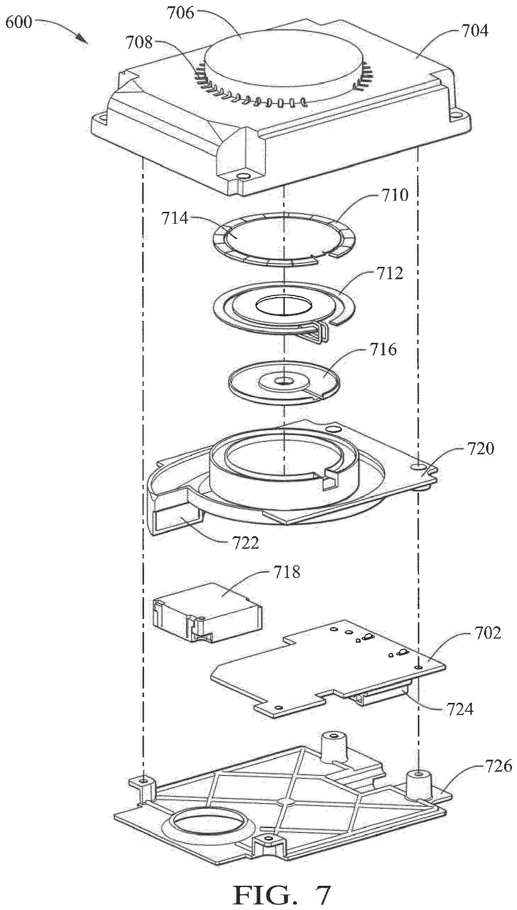

As shown in **FIG. 7****,** the device 600 includes an antenna printed circuit board assembly, hereafter referred to as the PCBA 702 having a plurality of electronic devices. These devices include microcontrollers, capacitors, resistors, diodes, transistors, etc., disposed on the PCBA 702. The device 600 also includes an outer housing 704 defining a pedestal 706 having a plurality of air vents 708 within the pedestal 706. The device 600 also includes a magnet array 710 which includes aligning magnets, such as those used with MAGSAFE^{™} devices or Magnetic Power Profile devices. Additionally, the device 600 includes a source coil 712, a ferrite 714, and a fan 718. The fan 718 is offset in the outer housing 704 from the source coil 712 and the ferrite 714. The device 600 has an inner housing 720 that forms an air duct 722 to direct an airflow from the fan 718 which flows through the device 600 and exits through the plurality of air vents 708. The fan 718 is arranged and located so that it will discharge the airflow into the air duct 722. The inner housing 720, in addition to forming the air duct 722 also houses/holds the PCBA 702, the magnet array 710, the source coil 712, and the ferrite 714. These items may increase in temperature during wireless charging. Since the air duct 722 is in contact with these components, the air flow through the air duct 722 will cool the PCBA 702, the magnet array 710, the source coil 712, and the ferrite 714 due to convective heat transfer. The device 600 also includes an antenna PCB 716 having an antenna, e.g., a near field communication (NFC) antenna, configured to communicate with the wireless charging enabled device.

**FIG. 7** shows the device 600 further includes an electrical connector 724 which is connected to the PCBA 702 and is configured to connect the device 600 to external electrical devices, such as power supplies or external sensors. The device 600 also has a bottom cover 726 enclosing the inner housing 720 in the outer housing 704.

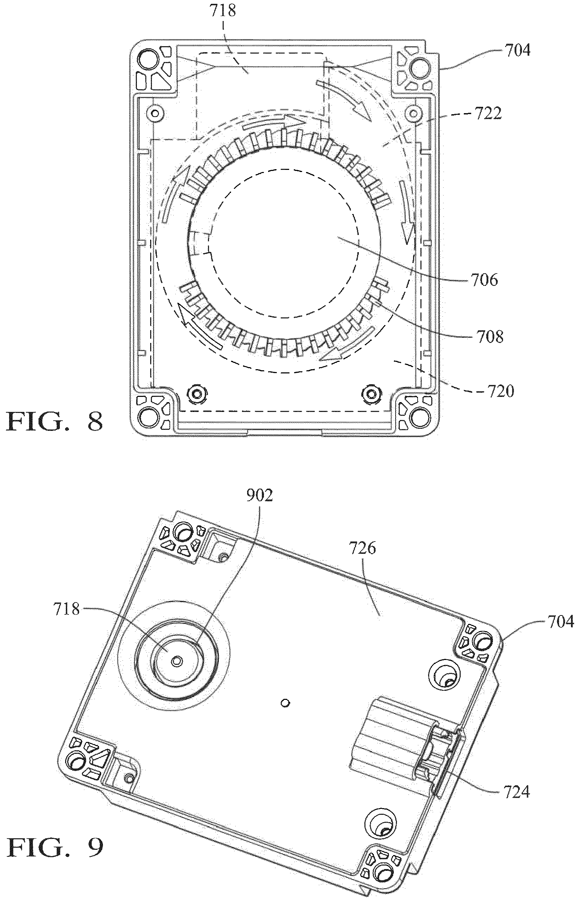

As shown in **FIG. 8****,** the air duct 722 is spirally or helically shaped in order to channel and direct the airflow around the magnet array 710 and the source coil 712 and ferrite 714 and then discharge the airflow from the outer housing 704 through plurality of air vents 708 which are the strategically sized & placed in the pedestal 706 of the outer housing.

**FIG. 9** is a bottom view of the device 600. The bottom cover 726 defines an air inlet 902 that allows air from outside the device 600 to be drawn into the device 600 by the fan 718.

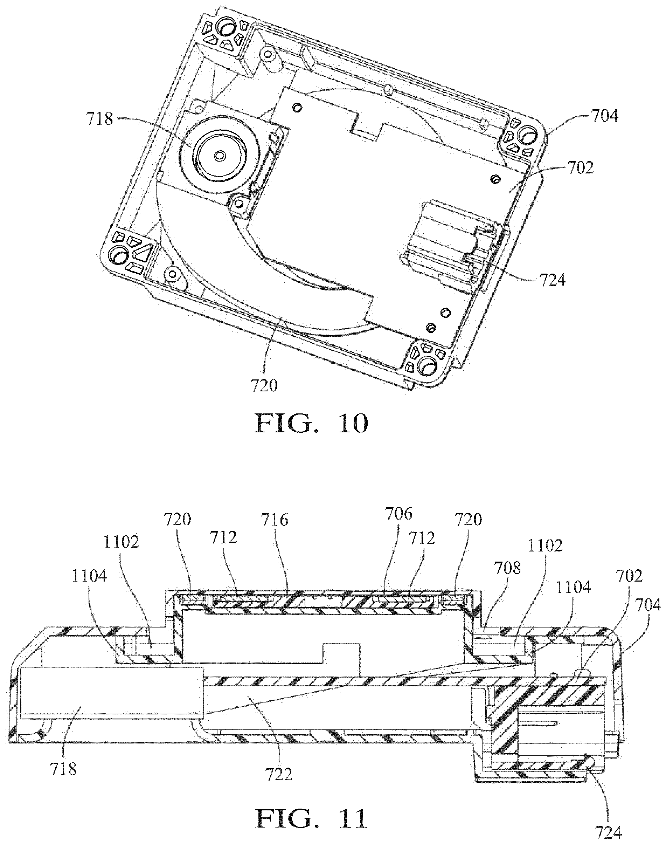

**FIG. 10** is a bottom view of the device 600 with the bottom cover 726 removed showing the positioning of the PCBA 702, fan 718, and inner housing 720 within the outer housing 704.

As shown in **FIG. 11****,** the inner housing 720 defines a channel 1102 formed by a wall 1104 in the air duct 722. The wall 1104 is positioned outboard of the plurality of air vents 106. The channel 1102 is configured to direct any liquids, e.g., water, soda, which may enter the device through the plurality of air vents 708 through the air duct 722 and out of the device 600 through the air inlet 902 in the bottom cover 726 under the force of gravity. The channel 222 is configured to protect the PCBA 702 and the fan 718 from contact with the liquid.

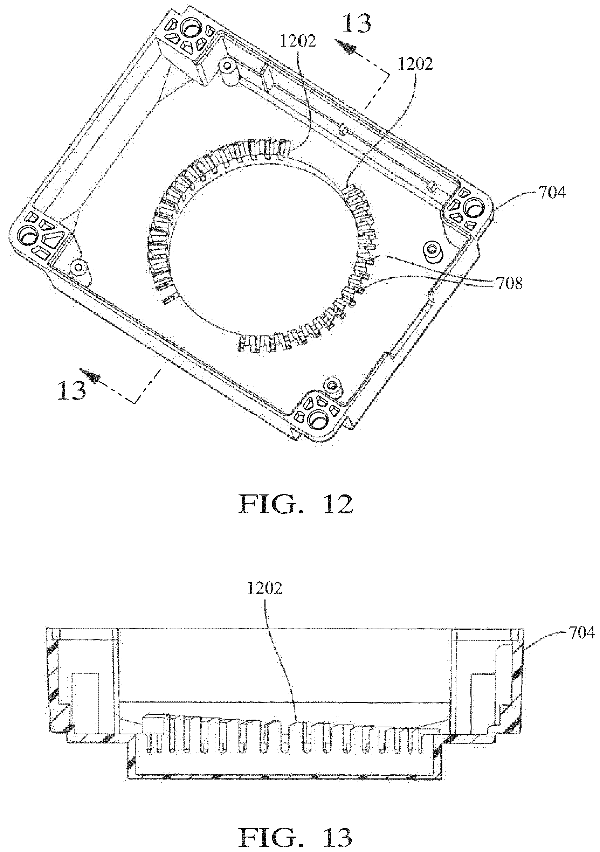

**FIG. 12** is a bottom view of the outer housing 704 illustrating a plurality of air flow deflectors 1202 in the form of rectangular prisms extending from an interior surface of the outer housing into the air duct 722. Each one of the plurality of deflectors 1202 is arranged adjacent to one of the plurality of air vents.

As can best be seen in **FIG. 13****,** one deflector in the plurality of deflectors is longer than an adjacent deflector in the plurality of deflectors. These deflectors 1202 are arranged such that each deflector 1202 in the plurality of deflectors 1202 is longer than its adjacent deflector 1202, i.e., a length of each deflector 1202 in the plurality of deflectors 1202 increases along a path of the airflow. The deflectors 1202 are sized, shaped, and arranged to produce a consistent pressure and volume of the air flow through each of the plurality of air vents 708.

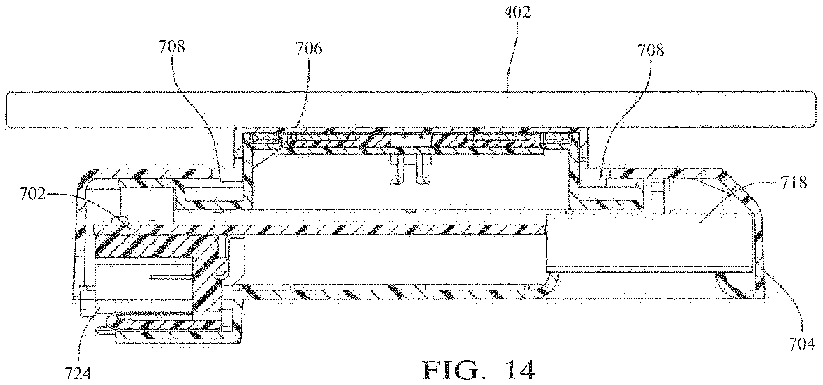

**FIG. 14** shows a cross-section view of the device 600 with the wireless charging enabled device 402 resting on the pedestal 706 and properly aligned with the source coil 712 by the magnet array 710.

### Discussion of Possible Embodiments

The following are non-exclusive descriptions of possible embodiments of the present invention.

In some aspects, the techniques described herein relate to a wireless charging device, including: a source coil configured to transmit electric power to a receiver coil in a separate device; a housing having a pedestal projecting from the housing in which the source coil is disposed. The housing defines a plurality of first air vents located circumferentially around the pedestal; an air movement device disposed within the housing and; and an electronic controller disposed on a printed circuit board and configured to control airflow through the air movement device.

The wireless charging device of the preceding paragraph can optionally include, additionally and/or alternatively any, one or more of the following features, configurations and/or additional components.

In some aspects, the techniques described herein relate to a wireless charging device, wherein the air movement device is arranged coaxially with the source coil.

In some aspects, the techniques described herein relate to a wireless charging device, wherein the electronic controller is configured to control a direction of airflow through the air movement device, wherein the air movement device is configured to draw air into the housing or exhaust air from the housing through the plurality of first air vents depending on the direction of the airflow through the air movement device.

In some aspects, the techniques described herein relate to a wireless charging device, wherein the housing defines a second air vent arranged coaxially with the air movement device, wherein air from the housing is exhausted through the second air vent when the air movement device draws air into the housing through the plurality of first air vents and wherein air is drawn into the housing through the second air vent when the air movement device exhausts air from the housing through the plurality of first air vents.

In some aspects, the techniques described herein relate to a wireless charging device, further including: a first temperature sensor and a second temperature sensor, each in communication with the electronic controller, wherein the electronic controller is configured to command the air movement device to draw air into the housing through the plurality of first air vents when the first temperature sensor indicates a higher temperature than the second temperature sensor and wherein the electronic controller is configured to command the air movement device to exhaust air from the housing through the plurality of first air vents when the first temperature sensor indicates a lower temperature than the second temperature sensor.

In some aspects, the techniques described herein relate to a wireless charging device, wherein the electronic controller is configured to command the air movement device to set an airflow rate based on a difference between a first temperature indicated by the first temperature sensor and a second temperature indicated by a second temperature sensor.

In some aspects, the techniques described herein relate to a wireless charging device, wherein the housing defines a channel configured to route a liquid entering any one of the plurality of first air vents to the second air vent.

In some aspects, the techniques described herein relate to a wireless charging device, wherein a bottom surface of the channel is arranged outwardly from the air movement device.

In some aspects, the techniques described herein relate to a wireless charging device, wherein a bottom surface of the channel is arranged below the air movement device.

In some aspects, the techniques described herein relate to a wireless charging device, wherein the air movement device is offset from the source coil and wherein the housing defines an air duct configured to direct the airflow into the housing through a second air vent, through the air movement device, and out of the housing through the plurality of first air vents.

In some aspects, the techniques described herein relate to a wireless charging device, wherein air duct is configured to direct the airflow around the source coil.

In some aspects, the techniques described herein relate to a wireless charging device, wherein air duct is configured to direct a liquid entering the housing through one of the plurality of first air vents to the second air vent and out of the housing, thereby directing the liquid away from the printed circuit board.

In some aspects, the techniques described herein relate to a wireless charging device, wherein the air duct contains a plurality of deflectors and where each one of the plurality of deflectors is arranged adjacent to one of the plurality of first air vents.

In some aspects, the techniques described herein relate to a wireless charging device, wherein one deflector in the plurality of deflectors is longer than an adjacent deflector in the plurality of deflectors.

In some aspects, the techniques described herein relate to a wireless charging device, wherein each deflector in the plurality of deflectors is longer than an adjacent deflector in the plurality of deflectors.

In some aspects, the techniques described herein relate to a wireless charging device, wherein a length of each deflector in the plurality of deflectors increases along a path of the airflow.

In some aspects, the techniques described herein relate to a wireless charging device, further including a plurality of aligning magnets disposed within the pedestal and arranged circumferentially around the source coil.

In some aspects, the techniques described herein relate to a wireless charging device, wherein the air movement device is a motor driven fan.

In some aspects, the techniques described herein relate to a wireless charging device, wherein the air movement device is a centrifugal fan.

While the invention has been described with reference to an exemplary embodiment(s), it will be understood by those skilled in the art that various changes may be made, and equivalents may be substituted for elements thereof without departing from the scope of the invention. In addition, many modifications may be made to adapt a particular situation or material to the teachings of the invention without departing from the essential scope thereof. Therefore, it is intended that the invention is not limited to the disclosed embodiment(s), but that the invention will include all embodiments falling within the scope of the appended claims.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of ordinance or orientation may be used herein these elements should not be limited by these terms. All terms of ordinance or orientation, unless stated otherwise, are used for purposes distinguishing one element from another, and do not denote any particular order, order of operations, direction or orientation unless stated otherwise.

In the following, further embodiments are described to facilitate understanding:
Embodiment 1. A wireless charging device (100, 600), comprising:
   a source coil (208, 712) configured to transmit electric power to a receiver coil in a separate device (402);
   a housing (204, 704) having a pedestal (102, 706) projecting from the housing in which the source coil (208, 712) is disposed, the housing (204, 704) defines a plurality of first air vents (106, 708) located circumferentially around the pedestal (102, 706); and
   an air movement device (214, 718) disposed within the housing (204, 704).
Embodiment 2. The wireless charging device (100) in accordance with Embodiment 1, wherein the air movement device (214) is arranged coaxially with the source coil (208).
Embodiment 3. The wireless charging device (100) in accordance with Embodiment 2, further comprising:
   an electronic controller (302) disposed on a printed circuit board (202) and configured to control airflow through the air movement device (204), wherein the electronic controller (302) is configured to control a direction of airflow through the air movement device (204), wherein the air movement device (204) is configured to draw air into the housing (204) or exhaust air from the housing (204) through the plurality of first air vents (106) depending on the direction of the airflow through the air movement device (204).
Embodiment 4. The wireless charging device (100) in accordance with Embodiment 3, wherein the housing (204) defines a second air vent arranged coaxially with the air movement device (204), wherein air from the housing (204) is exhausted through the second air vent (220) when the air movement device (204) draws air into the housing (204) through the plurality of first air vents (106) and wherein air is drawn into the housing (204) through the second air vent (220) when the air movement device (204) exhausts air from the housing (204) through the plurality of first air vents (106).
Embodiment 5. The wireless charging device (100) in accordance with Embodiment 4, further comprising:
   a first temperature sensor (304) and a second temperature sensor (306), each in communication with the electronic controller (302), wherein the electronic controller (302) is configured to command the air movement device (204) to draw air into the housing (204) through the plurality of first air vents (106) when the first temperature sensor (304) indicates a higher temperature than the second temperature sensor (306) and wherein the electronic controller (302) is configured to command the air movement device (204) to exhaust air from the housing (204) through the plurality of first air vents (106) when the first temperature sensor (304) indicates a lower temperature than the second temperature sensor (306).
Embodiment 6. The wireless charging device (100) in accordance with Embodiment 5, wherein the electronic controller (302) is configured to command the air movement device (204) to set an airflow rate based on a difference between a first temperature indicated by the first temperature sensor (304) and a second temperature indicated by a second temperature sensor (306).
Embodiment 7. The wireless charging device (100) in accordance with Embodiment 4, wherein the housing (204) defines a channel (222) configured to route a liquid entering any one of the plurality of first air vents (106) to the second air vent (220).
Embodiment 8. The wireless charging device (100) in accordance with Embodiment 7, wherein a bottom surface of the channel (222) is arranged outwardly from the air movement device (204).
Embodiment 9. The wireless charging device (100) in accordance with Embodiment 7, wherein a bottom surface of the channel (222) is arranged below the air movement device (204).
Embodiment 10. The wireless charging device (600) in accordance with Embodiment 1, wherein the air movement device (718) is offset from the source coil (712) and wherein the housing defines an air duct (722) configured to direct the airflow into the housing (704) through a second air vent, (902) through the air movement device (718), and out of the housing through the plurality of first air vents (708).
Embodiment 11. The wireless charging device (600) in accordance with Embodiment 10, wherein the air duct (722) is configured to direct the airflow around the source coil (712).
Embodiment 12. The wireless charging device (600) in accordance with Embodiment 10, further comprising:
   an electronic controller (302) disposed on a printed circuit board (702) and configured to control airflow through the air movement device (718), wherein the air duct (722) is configured to direct a liquid entering the housing (704) through one of the plurality of first air vents (708) to the second air vent (902) and out of the housing (704), thereby directing the liquid away from the printed circuit board (702).
Embodiment 13. The wireless charging device (600) in accordance with Embodiment 11, wherein the air duct (722) contains a plurality of deflectors (1202) and where each one of the plurality of deflectors (1202) is arranged adjacent to one of the plurality of first air vents (708) and wherein one deflector in the plurality of deflectors (1202) is longer than an adjacent deflector in the plurality of deflectors (1202).
Embodiment 14. The wireless charging device (600) in accordance with Embodiment 13, wherein each deflector in the plurality of deflectors (1202) is longer than an adjacent deflector in the plurality of deflectors (1202) and wherein a length of each deflector in the plurality of deflectors (1202) increases along a path of the airflow.
Embodiment 15. The wireless charging device (100, 600) in accordance with anu of the preceding Embodiments, further comprising a plurality of aligning magnets (206, 710) disposed within the pedestal (102, 706) and arranged circumferentially around the source coil (208, 712).

## Claims

1. A wireless charging device (100, 600), comprising:
a source coil (208, 712) configured to transmit electric power to a receiver coil in a separate device (402);
a housing (204, 704) having a pedestal (102, 706) projecting from the housing in which the source coil (208, 712) is disposed, the housing (204, 704) defines a plurality of first air vents (106, 708) located circumferentially around the pedestal (102, 706); and
an air movement device (214, 718) disposed within the housing (204, 704).

2. The wireless charging device (100) in accordance with claim 1, wherein the air movement device (214) is arranged coaxially with the source coil (208).

3. The wireless charging device (100) in accordance with claim 1 or 2, further comprising:
an electronic controller (302) disposed on a printed circuit board (202) and configured to control airflow through the air movement device (204), wherein the electronic controller (302) is configured to control a direction of airflow through the air movement device (204), wherein the air movement device (204) is configured to draw air into the housing (204) or exhaust air from the housing (204) through the plurality of first air vents (106) depending on the direction of the airflow through the air movement device (204).

4. The wireless charging device (100) in accordance with any one of the preceding claims, wherein the housing (204) defines a second air vent arranged coaxially with the air movement device (204), wherein air from the housing (204) is exhausted through the second air vent (220) when the air movement device (204) draws air into the housing (204) through the plurality of first air vents (106) and wherein air is drawn into the housing (204) through the second air vent (220) when the air movement device (204) exhausts air from the housing (204) through the plurality of first air vents (106).

5. The wireless charging device (100) in accordance with claim 3, optionally in combination with claim 4, further comprising:
a first temperature sensor (304) and a second temperature sensor (306), each in communication with the electronic controller (302), wherein the electronic controller (302) is configured to command the air movement device (204) to draw air into the housing (204) through the plurality of first air vents (106) when the first temperature sensor (304) indicates a higher temperature than the second temperature sensor (306) and wherein the electronic controller (302) is configured to command the air movement device (204) to exhaust air from the housing (204) through the plurality of first air vents (106) when the first temperature sensor (304) indicates a lower temperature than the second temperature sensor (306).

6. The wireless charging device (100) in accordance with claim 5, wherein the electronic controller (302) is configured to command the air movement device (204) to set an airflow rate based on a difference between a first temperature indicated by the first temperature sensor (304) and a second temperature indicated by a second temperature sensor (306).

7. The wireless charging device (100) in accordance with claim 4, optionally in combination with claim 5 or 6, wherein the housing (204) defines a channel (222) configured to route a liquid entering any one of the plurality of first air vents (106) to the second air vent (220).

8. The wireless charging device (100) in accordance with claim 7, wherein a bottom surface of the channel (222) is arranged outwardly from the air movement device (204).

9. The wireless charging device (100) in accordance with claim 7 or 8, wherein a bottom surface of the channel (222) is arranged below the air movement device (204).

10. The wireless charging device (600) in accordance with claim 1, wherein the air movement device (718) is offset from the source coil (712) and wherein the housing defines an air duct (722) configured to direct the airflow into the housing (704) through a second air vent, (902) through the air movement device (718), and out of the housing through the plurality of first air vents (708).

11. The wireless charging device (600) in accordance with claim 10, wherein the air duct (722) is configured to direct the airflow around the source coil (712).

12. The wireless charging device (600) in accordance with claim 10 or 11, further comprising:
an electronic controller (302) disposed on a printed circuit board (702) and configured to control airflow through the air movement device (718), wherein the air duct (722) is configured to direct a liquid entering the housing (704) through one of the plurality of first air vents (708) to the second air vent (902) and out of the housing (704), thereby directing the liquid away from the printed circuit board (702).

13. The wireless charging device (600) in accordance with any one of claims 10 to 12, wherein the air duct (722) contains a plurality of deflectors (1202) and where each one of the plurality of deflectors (1202) is arranged adjacent to one of the plurality of first air vents (708) and wherein one deflector in the plurality of deflectors (1202) is longer than an adjacent deflector in the plurality of deflectors (1202).

14. The wireless charging device (600) in accordance with claim 13, wherein each deflector in the plurality of deflectors (1202) is longer than an adjacent deflector in the plurality of deflectors (1202) and wherein a length of each deflector in the plurality of deflectors (1202) increases along a path of the airflow.

15. The wireless charging device (100, 600) in accordance with any of the preceding claims, further comprising a plurality of aligning magnets (206, 710) disposed within the pedestal (102, 706) and arranged circumferentially around the source coil (208, 712).
